# EUROPEAN PATENT APPLICATION

(11) **EP 2 461 372 A1**
(43) Date of publication of application: **06.06.2012**
(21) Application number: 10804465.2
(22) Date of filing: 28.07.2010
(51) Int. Cl.: H01L 31/075, H01L 31/0224, H01B 5/14, C23C 16/40

(54) **TRANSPARENT CONDUCTIVE SUBSTRATE FOR SOLAR CELL, AND SOLAR CELL**

(30) Priority: 29.07.2009 JP 2009176401
(71) Applicant: Asahi Glass Company, Limited, Chiyoda-ku Tokyo 100-8405 (JP)
(72) Inventor: MATSUI, Yuji, Tokyo 100-8405 (JP); KATO, Toshimichi, Tokyo 100-8405 (JP)
(74) Representative: Müller-Boré & Partner Patentanwälte
(86) International application number: PCT/JP2010/062730
(87) International publication number: WO 2011/013719

(57) **Abstract**

To provide a transparent conductive substrate for a solar cell, whereby the fill factor (FF) and the open circuit voltage can be improved, and a solar cell using it.

A transparent conductive substrate for a solar cell, comprising a substrate and at least a tin oxide layer formed thereon, wherein the tin oxide layer has ridges and dents on a surface which is not on the substrate side, an oxide having titanium as the main component is formed on the surface having the ridges and dents, the oxide is particles having an average size of from 1 to 100 nm, and the oxide is contained at a density of from 10 to 100 particles/µm².

## Description

### TECHNICAL FIELD

The present invention relates to a transparent conductive substrate for a solar cell, and a solar cell:

### BACKGROUND ART

Solar cells are desired to have their photoconversion efficiency increased in order to utilize the incident sunlight energy to the maximum extent.

As a means to increase the photoelectric conversion efficiency, it is known to increase the electric current flowing through a transparent conductive substrate for a solar cell to be used as an electrode for solar cells. For such a purpose, it is known to increase the haze factor, and a method of forming irregularities (ridges and dents) on the surface of a conductive film (tin oxide layer) is, for example, known (e.g. Patent Documents 1 to 5).

### PRIOR ART DOCUMENTS

### PATENT DOCUMENTS

Patent Document 1: JP-A-2002-260448
Patent Document 2: JP-A-2001-36117
Patent Document 3: WO2004/102677
Patent Document 4: WO2005/027229
Patent Document 5: WO2007/058118

### DISCLOSURE OF INVENTION

### TECHNICAL PROBLEM

However, as a result of a study by the present inventors, it has been found that at the time of producing solar cells using a substrate having ridges and dents on a surface of a conductive film (tin oxide layer), a photoelectric conversion layer, particularly a p layer, formed on a surface of the tin oxide layer is not formed with a uniform film thickness in some cases, and as a result, a fill factor (FF) or open circuit voltage (Voc) which influences the photoelectric conversion efficiency, becomes low.

Accordingly, it is an object of the present invention to provide a transparent conductive substrate for a solar cell, whereby the fill factor (FF) and open circuit voltage (Voc) can be improved, and a solar cell provided with it.

### SOLUTION TO PROBLEM

As a result of an extensive research to solve the above problem, the present inventors have found that by providing an oxide having titanium as the main component and having a specific size at a specific density on a surface of a tin oxide layer in a transparent conductive substrate for a solar cell, which comprises at least a substrate and the tin oxide layer formed thereon, the ill factor (FF) and the open circuit voltage (Voc) of a solar cell using such a substrate can be improved.

That is, the present invention provides the following (1) to (6).
(1) A transparent conductive substrate for a solar cell, comprising a substrate and at least a tin oxide layer formed thereon, wherein the tin oxide layer has ridges and dents on a surface which is not on the substrate side, an oxide having titanium as the main component is formed on the surface having the ridges and dents, the oxide is particles having an average size of from 1 to 100 nm, and the oxide is contained at a density of from 10 to 100 particles/µm².
(2) The transparent conductive substrate according to the above (1), wherein the average size of the oxide is from 10 to 50 nm.
(3) The transparent conductive substrate according to the above (1) or (2), wherein the density of the oxide is from 20 to 70 particles/µm².
(4) The transparent conductive substrate according to any one of the above (1) to (3), wherein the tin oxide layer is formed at a temperature of the substrate of from 500 to 550°C, and the oxide is formed on the tin oxide layer while maintaining the temperature of the substrate at the time of forming the tin oxide layer.
(5) The transparent conductive substrate according to the above (1), wherein on a surface of the tin oxide layer having ridges and dents wherein the height difference between ridge parts and dent parts of the ridges and dents on the tin oxide layer is from 0.1 to 0.5 µm, and pitches between the ridge parts of the ridges and dents is from 0.1 to 0.75 µm, particles of the oxide having titanium as the main component and having an average size of from 1 to 100 nm are formed at a density of from 10 to 100 particles/µm².
(6) A solar cell, which has the transparent conductive substrate for a solar cell as defined in any one of the above (1) to (5).
(7) A process for producing the transparent conductive substrate for a solar cell as defined in the above (1), which comprises at least a tin oxide layer forming step of forming the tin oxide layer on the substrate and an oxide forming step of forming the oxide on the surface of the tin oxide layer for obtaining a transparent conductive substrate for a solar cell, wherein the temperature of the substrate at the tin oxide layer forming step and the oxide forming step is from 500 to 550°C, and the temperature of the substrate is maintained at from 500 to 550°C between these steps.
(8) The process for producing the transparent conductive substrate for a solar cell according to the above (7), wherein the tin oxide layer forming step of forming the tin oxide layer having ridges and dents on a surface is carried out by an atmospheric pressure CVD method, the oxide forming step of forming oxide particles having titanium as the main component on the surface of the tin oxide layer having ridges and dents on a surface formed by the atmospheric pressure CVD method is carried out by an atmospheric pressure CVD method, and the oxide at the oxide forming step is formed on the tin oxide layer, while maintaining the temperature of the substrate at the time of forming the tin oxide layer at the tin oxide layer forming step.

### ADVANTAGEOUS EFFECTS OF INVENTION

As will be described below, according to the present invention, it is possible to provide a transparent conductive substrate for a solar cell, whereby the fill factor (FF) and the open circuit voltage (Voc) can be improved, and a solar cell provided with it.

### BRIEF DESCRIPTION OF DRAWINGS

Fig. 1 is a schematic cross-sectional view illustrating one embodiment of the transparent conductive substrate for a solar cell of the present invention.
Fig. 2 is a schematic cross-sectional view illustrating a state wherein a photoelectric conversion layer is formed in conventional solar cells.
Fig. 3 is a schematic cross-sectional view illustrating a state wherein a photoelectric conversion layer is formed in the solar cell of the present invention.
Fig. 4 is a schematic cross-sectional view illustrating one embodiment of a solar cell of a tandem structure employing the transparent conductive substrate for a solar cell of the present invention.
Fig. 5 is an electron microscopic photograph showing the surface of the transparent conductive film substrate for a solar cell produced in Comparative Example 1.
Fig. 6 is an electron microscopic photograph showing the surface of the transparent conductive film substrate for a solar cell produced in Example 1.
Fig. 7 is an electron microscopic photograph showing the surface of the transparent conductive film substrate for a solar cell produced in Example 2.
Fig. 8 is an electron microscopic photograph showing the surface of the transparent conductive film substrate for a solar cell produced in Example 3.
Fig. 9 is an electron microscopic photograph showing the surface of the transparent conductive film substrate for a solar cell produced in Example 4.

### DESCRIPTION OF EMBODIMENTS

Now, the present invention will be described in detail.

The transparent conductive substrate for a solar cell of the present invention is a transparent conductive substrate for a solar cell, comprising a substrate and at least a tin oxide layer formed thereon, wherein the tin oxide layer has ridges and dents on a surface which is not the substrate side, an oxide having titanium as the main component (hereinafter referred to as "titanium oxide" unless otherwise specified) is formed on the surface having the ridges and dents, the oxide is particles having an average size of from 1 to 100 nm, and the oxide is contained at a density of from 10 to 100 particies/µm².

Next, the structure of the transparent conductive substrate for a solar cell of the present invention will be described with reference to one example of preferred embodiments shown in the attached drawings.

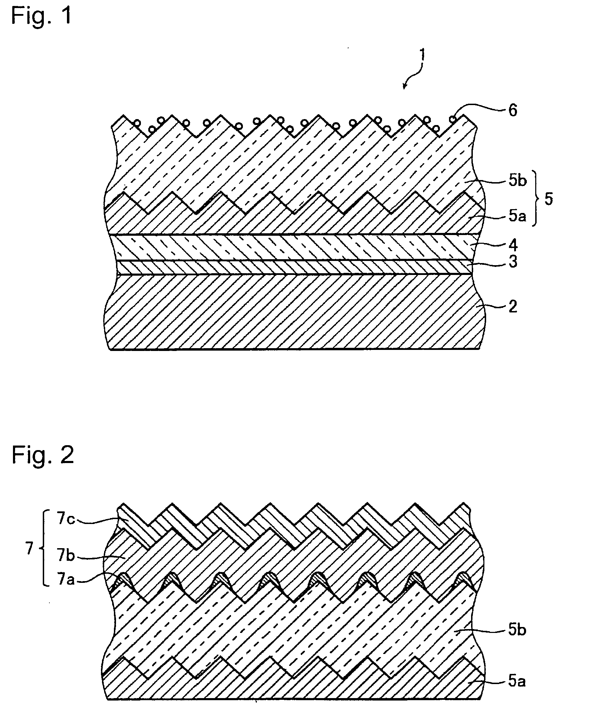

Fig. 1 is a schematic cross-sectional view illustrating one practical example of the embodiment of the transparent conductive substrate for a solar cell of the present invention. In Fig. 1, the incident light side of the transparent conductive substrate for a solar cell is located on the down side of the drawing.

As shown in Fig. 1, the transparent conductive substrate 1 for a solar cell has, on a substrate 2, a titanium oxide layer 3, a silicon oxide layer 4, a tin oxide layer 5 and particles of titanium oxide 6 in this order from the substrate 2 side.

As mentioned later, it is one of preferred embodiments that the transparent conductive substrate for a solar cell is provided with a titanium oxide layer 3 and a silicon oxide layer 4, and the tin oxide layer 5 is formed as two layers of a first tin oxide layer 5a and a second tin oxide layer 5b, i.e. not as one layer.

### <SUBSTRATE>

The material for the substrate 2 is not particularly limited, but glass or a plastic may, for example, be preferably mentioned from the viewpoint of being excellent in the light transmitting property (the light transmittance) and the mechanical strength. Among them, glass is particularly preferred from the viewpoint of being excellent in the light transmittance, the mechanical strength and the heat resistance and excellent also from the aspect of costs.

The glass is not particularly limited, and it may, for example, be soda lime silicate glass, aluminosilicate glass, lithium aluminosilicate glass, quartz glass, borosilicate glass or alkali-free glass. Among them, soda lime silicate glass is particularly preferred from the viewpoint of being colorless transparent, inexpensive and readily available in the market by specifying the specification for e.g. the area, shape, thickness, etc.

In a case where the substrate 2 is made of glass, the thickness is preferably from 0.2 to 6.0 mm. Within this range, the balance between the mechanical strength and the light transmitting property will be excellent.

The substrate 2 is preferably one excellent in the light transmittance within a wavelength region of from 400 to 1,200 nm. Specifically, it is preferred that the average light transmittance within a wavelength region of from 400 to 1,200 nm exceeds 80%, and it is more preferably at least 85%.

Further, the substrate 2 is preferably one excellent in the insulating properties and preferably one excellent also in the chemical durability and the physical durability.

The substrate 2 shown in Fig. 1 is a flat plate with a flat cross-sectional shape. However, in the present invention, the cross-sectional shape of the substrate is not particularly limited, and it may be suitably selected depending upon the shape of the solar cell to be produced by employing the substrate 2. Namely, the cross-sectional shape may be a curved shape or any other irregular shape.

### <TITANIUM OXIDE LAYER>

In Fig. 1, the titanium oxide layer 3 is formed on the substrate 2.

In the present invention, when the substrate is made of glass, an embodiment having a titanium oxide layer between the substrate and a silicon oxide layer is one of preferred embodiments, since it is possible to suppress reflection at the interface between the substrate and the tin oxide layer which takes place due to the difference in the refractive index between the substrate and the tin oxide layer.

The titanium oxide layer 3 is a layer made of TiO₂ having a higher refractive index than the substrate 2 to a light within a wavelength region of from 400 to 1,200 nm. The titanium oxide layer 3 is a layer composed substantially of TiO₂ and the proportion of TiO₂ among components contained in the layer is preferably at least 90 mol%, more preferably at least 95 mol%, further preferably at least 98 mol%.

The titanium oxide layer 3 preferably has a thickness of at least 5 nm and less than 22 nm, more preferably from 10 to 20 nm. Within such a range, the fluctuation in the haze factor for illuminant C is small when the transparent conductive substrate 1 for a solar cell is viewed as a whole, and by the anti-reflection effects, the light transmittance, particularly the light transmittance within a wavelength region of from 400 to 1,200 nm, can be made higher.

The titanium oxide layer 3 preferably has a surface arithmetic average roughness (Rₐ) of at most 3 nm, more preferably at most 1 nm, as measured by an atomic force microscope (AFM), before the silicon oxide layer 4 is formed thereon.

### <SILICON OXIDE LAYER>

In Fig. 1, on the titanium oxide layer 3, a silicon oxide layer 4 is formed. The embodiment having a silicon oxide layer is one of preferred embodiments of the present invention, since in a case where the substrate is made of glass, the silicon oxide layer suppresses diffusion of alkali metal ions from the substrate.

The silicon oxide layer 4 is a layer made of SiO₂ having a lower refractive index to a light within a wavelength region of from 400 to 1,200 nm than the substrate 2, and the first tin oxide layer 5a and the second tin oxide layer 5b which are formed as a case requires. The silicon oxide layer 4 is a layer composed substantially of SiO₂, and the proportion of SiO₂ among the components contained in the layer is preferably at least 90 mol%, more preferably at least 95 mol%, further preferably at least 98 mol%.

The silicon oxide layer 4 preferably has a thickness of from 10 to 50 nm, more preferably from 20 to 40 nm, further preferably from 20 to 35 nm. Within such a range, the haze factor for illuminant C of the transparent conductive substrate for a solar cell will be high, and the fluctuation in the haze factor for illuminant C is small when the transparent conductive substrate 1 for a solar cell is viewed as a whole.

The silicon oxide layer 4 preferably has a surface arithmetic average roughness (Rₐ) of at most 3 nm, more preferably at most 1 nm, as measured by an atomic force microscope (AFM), before the tin oxide layer 5 (the first tin oxide layer 5a) is formed thereon.

Further, the silicon oxide layer 4 functions as a reflective-preventive layer in combination with the titanium oxide layer 3.

Specifically, the transparent conductive substrate 2 for a solar cell has the titanium oxide layer 3 having a higher refractive index to a light within a wavelength region of from 400 to 1,200 nm than the substrate 2, and the silicon oxide layer 4 having a lower refractive index to light within a wavelength region of from 400 to 1,200 nm than the tine oxide layer 5 (the first tin oxide layer 5a), between the substrate 2 and the tin oxide layer 5 (the first tin oxide layer 5a), whereby the reflection loss of incident light will be reduced, and the light transmittance, particularly the light transmittance within a wavelength region of from 400 to 1,200 nm, will be high.

Further, in a case where the material for the substrate 2 is a glass containing alkali metal ions such as soda lime silicate glass or low alkali-containing glass, the silicon oxide layer will function also as an alkali barrier layer to minimize the diffusion of alkali metal ions from the substrate 2 to the tin oxide layer 5 (the first tin oxide layer 5a).

### <TIN OXIDE LAYER>

In Fig. 1, on the silicon oxide layer 4, the first tin oxide layer 5a is formed, and on the first tin oxide layer 5a, the second tin oxide layer 5b is formed.

In the present invention, the tin oxide layer may be formed as one layer, however, as one of preferred embodiments, a multi-layered (in Fig. 1, two layers) tin oxide layer is formed on the silicon oxide layer, since the resistance of the tin oxide layer is maintained to be low, and the absorption of near infrared light by the tin oxide layer can be reduced.

The following description will be made with reference to e.g. a case where the first tin oxide layer 5a is a tin oxide layer not doped with fluorine, and the second tin oxide layer 5b is a tin oxide layer doped with fluorine.

Usually, if a tin oxide layer is doped with fluorine, the amount of free electrons (carrier concentration) in the layer will increase.

Here, the free electrons in the layer will lower the resistance and increase the electrical conductivity. From such a viewpoint, the larger the amount the better. However, they tend to absorb near infrared light, whereby light reaching to the semiconductor layer will be reduced. From such a viewpoint, the smaller the amount, the better.

In the transparent conductive substrate 1 for a solar cell shown on Fig. 1, while the second tin oxide layer 5b is doped with fluorine, the first tin oxide layer 5a is not doped with fluorine, whereby as compared with the conventional transparent conductive substrate for a solar cell wherein the entire tin oxide layer is doped with fluorine, the entire amount of fluorine doped, can be made small, and accordingly, the entire amount of free electrons in the layer can be made small. As a result, it is possible to lower the absorption of near infrared light.

On the other hand, the electric current flows mainly through the second tin oxide layer 5b having a large amount of free electrons and a low resistance, whereby there will be little influence by the first tin oxide layer 5a having a high resistance. Namely, as the tin oxide layers as a whole, electrical conductivity of the same degree can be secured as compared with the conventional transparent conductive substrate for a solar cell wherein the entire tin oxide layer is doped with fluorine.

The tin oxide layer doped with fluorine is a layer composed mainly of SnO₂, and the proportion of SnO₂ among the components contained in the layer is preferably at least 90 mol%, more preferably at least 95 mol%.

The concentration of fluorine in the tin oxide layer doped with fluorine is preferably from 0.01 to 4 mol%, more preferably from 0.02 to 2 mol%, to SnO₂. Within such a range, the electrical conductivity will be excellent.

In the tin oxide layer doped with fluorine, the free electron density is high, as it is doped with fluorine. Specifically, the free electron density is preferably from 5×10¹⁹ to 4×10²⁰ cm⁻³, more preferably from 1×10²⁰ to 2×10²⁰ cm⁻³. Within such a range, the balance between the electrical conductivity and the absorption of near infrared light will be excellent.

The tin oxide layer not doped with fluorine may be a layer composed substantially of SnO₂ and may contain fluorine to some extent. For example, it may contain fluorine to some extent as a result of transfer and diffusion of fluorine from the tin oxide layer doped with fluorine.

In the tin oxide layer not doped with fluorine, the proportion of SnO₂ among components contained in the layer, is preferably at least 90 mol%, more preferably at least 95 mol%, further preferably at least 98 mol%. Within such a range, the absorption of near infrared light can be made sufficiently low.

The tin oxide layer (as a whole in the case of the multi-layers) preferably has a sheet resistance of from 5 to 20 Ω/□, more preferably from 5 to 10 Ω/□.

The tin oxide layer (the total in the case of the multi-layers) preferably has a thickness of from 600 to 1,200 nm, more preferably from 700 to 1,000 nm. Within such a range, the haze factor for illuminant C of the transparent conductive substrate 1 for a solar cell will be particularly high, and its fluctuation will be particularly small. Further, the light transmittance, particularly the light transmittance within a wavelength region of from 400 to 1,200 nm, will be particularly high, and the electrical conductivity of the tin oxide layers will be particularly excellent. Here, the thickness of the tin oxide layers is a thickness to the top of the ridge parts. Specifically, it is measured by a stylus-type thickness meter.

The thickness of the tin oxide layer not doped with fluorine (the total thickness in a case where a plurality of such layers are present) is preferably from 10 to 600 nm, more preferably from 20 to 500 nm. Within such a range, the effect to suppress the absorption of near infrared light will be sufficiently large.

The thickness of the tin oxide layer doped with fluorine (the total thickness in a case where a plurality of such layers are present) is preferably from 100 to 700 nm, more preferably from 200 to 500 nm. Within such a range, the effects to lower the resistance will be sufficiently large.

The ratio of the thickness of the tin oxide layer not doped with fluorine (the total thickness in a case where a plurality of such layers are present) to the thickness of the tin oxide layer doped with fluorine (the total thickness in a case where a plurality of such layers are present) is preferably 3/7 to 7/3. Within such a range, the balance between the effects to suppress the absorption of near infrared light and the effects to lower the resistance will be excellent.

As shown in Fig. 1, in the case where the tin oxide layer 5 is formed as two layers, the first tin oxide layer 5a being a tin oxide layer adjacent to the silicon oxide layer is preferably a tin oxide layer not doped with fluorine.

As described above, in the present invention, one having a titanium oxide layer is one of preferred embodiments. However, in an embodiment having a titanium oxide layer, the function as an alkali barrier layer of the silicon oxide layer tends to be low. Consequently, if the substrate is a glass containing alkali metal ions, the alkali metal ions such as sodium ions tend to pass through the silicon oxide layer and move to the interface with the first tin oxide layer. The alkali metal ions such as sodium ions have a function to reduce the size of crystallites during the formation of the first tin oxide layer, whereby the irregularities on the surface of the tin oxide layer tend to be small (the details will be described hereinafter), and consequently the haze factor tends to be small.

Here, in a case where the first tin oxide layer is not doped with fluorine, the size of crystallites tends to be large as compared with a case where the first tin oxide layer is doped with fluorine, whereby the surface irregularities of the tin oxide layer tend to be large, and the haze factor tends to be large, such being desirable. The reason may be such that when the first tin oxide layer is doped with fluorine, F⁻ will electrically attract Na⁺, etc., thereby to accelerate the movement of the alkali metal ions to the interface with the first tin oxide layer, while such will not happen if the first tin oxide layer is not doped with fluorine.

In a case where the first tin oxide layer 5a is not doped with fluorine, the fluorine concentration in the first tin oxide layer 5a is preferably not more than 20% of the fluorine concentration in the tin oxide layer doped with fluorine (the second tin oxide layer 5b).

Even if the first tin oxide layer 5a is not doped with fluorine, if the adjacent second tin oxide layer 5b is doped with fluorine, during its film-forming process, a part of such fluorine will move and diffuse into the first tin oxide layer 5a. Even if the fluorine is diffused, if the fluorine concentration in the first tin oxide layer 5a is not more than 20% of the fluorine concentration in the second tin oxide layer 5b, the function to reduce the size of crystallites will be suppressed, the surface irregularities of the tin oxide layer will be large, and the haze factor will be sufficiently large.

In the present invention, the fluorine concentration is measured by means of Secondary Ion Mass Spectroscopy (SIMS). Specifically, the fluorine concentration can be calculated from the counted amount of F ions measured by means of SIMS.

Depending upon sputtering ions to be used, the sensitivity to Sn ions and the sensitivity to F ions are different. However, so long as the same sputtering ions are employed, the sensitivity will be constant. Accordingly, by using the same sputtering ions, it is possible to compare the ratio of the counted amount of Sn ions to the counted amount of F ions at different measuring portions.

The thickness of the first tin oxide layer 5a is preferably at least 10 nm, more preferably at least 50 nm, since the crystallites will thereby be large.

In Fig. 1, the first tin oxide layer usually covers the entire surface of the silicon oxide layer. However, in the present invention, a part thereof may not be covered. Namely, there may be a portion where the silicon oxide layer and the second tin oxide layer are in direct contact with each other. In such a case, the first tin oxide layer may be non-continuous (in other words, the first tin oxide layer may be scattered in the form of islands on the silicon oxide layer).

In the present invention, as shown in Fig. 1, the tin oxide layer (in the case of the multi-laminated tin oxide layers, the outermost tin oxide layer from the substrate) preferably has irregularities over the entire surface on the opposite side to the incident light side (in Fig. 1, on the upper surface of the second tin oxide layer 5b). With respect to the degree of irregularities, the height difference (height difference between ridges and dents) is preferably from 0.1 to 0.5 µm, more preferably from 0.2 to 0.4 µm. Further, the pitch between the ridges of the irregularities (the distance between the peaks of adjacent ridges) is preferably from 0.1 to 0.75 µm, more preferably from 0.2 to 0.45 µm. Here, a numerical value of the height difference means that an average value of randomly selected 10 height differences falls within the range of the numerical value of the height difference. Further, in a case where numerical values of 10 height differences include a value without the range, such a value without the range preferably falls within the range of 10% from the lower limitation to 20% from the upper limitation. A numerical value of the pitch means that an average value of randomly selected 10 pitches falls within the range of the numerical value of the pitch. Further, in a case where numerical values of 10 pitches include a value without the range, such a value without the range preferably falls within the range of 10% from the lower limitation to 20% from the upper limitation.

When the tin oxide layer has irregularities on its surface, the haze factor of the transparent conductive substrate for a solar cell will be high due to light scattering. Further, it is preferred that such irregularities are uniform over the entire surface of the tin oxide layer, since the fluctuation in the haze factor will thereby be small.

When the transparent conductive substrate for a solar cell has irregularities on the surface of the tin oxide layer, the haze factor will be large. Further, when the tin oxide layer has irregularities on its surface, light will be refracted at the interface between the tin oxide layer and a semiconductor layer. Further, when the tin oxide layer has irregularities on its surface, the interface of the semiconductor layer formed thereon with the rear electrode layer will likewise have irregularities, whereby light tends to be readily scattered.

When the haze factor becomes large, an effect such that the length (light path length) for light to travel back and forth through the semiconductor layer between the transparent conductive film (the tin oxide layer thereof) and the rear electrode layer will be long (an effect to trap light in) will be obtained, whereby the electric current value will increase.

A method for forming such irregularities on the surface of the tin oxide layer is not particularly limited. The irregularities will be composed of crystallites exposed on the surface of the tin oxide layer remotest from the substrate on the opposite side to the incident light side.

Usually, in the multi-laminated tin oxide layers, it is possible to adjust the size of crystallites in the tin oxide layer remotest from the substrate by adjusting the size of crystallites in the first tin oxide layer, whereby the irregularities can be controlled to be within the above-mentioned preferred range. Also in the transparent conductive substrate 1 for a solar cell shown in Fig. 1, the first tin oxide layer 5a has irregularities on its surface, whereby the second tin oxide layer 5b has irregularities on its surface.

In order to enlarge the size of crystallites in the first tin oxide layer, a method may, for example, be mentioned wherein the concentration of fluorine is made small without doping fluorine, as mentioned above.

The thickness of the transparent conductive film formed on the substrate (in the transparent conductive substrate 1 for a solar cell shown in Fig. 1, the total of the thicknesses of the first tin oxide layer 5a and the second tin oxide layer 5b) is preferably from 600 to 1,200 nm as mentioned above. Within such a range, the irregularities will not be too deep, whereby uniform coating with silicon will be facilitated, and the cell efficiency is likely to be excellent. Namely, the thickness of the p-layer of a photoelectric conversion layer is usually at a level of a few tens nm, and accordingly, if the irregularities are too deep, the dent portions are likely to have structural defects, or the raw material diffusion to the dent portions tends to be insufficient, whereby uniform coating tends to be difficult, and the cell efficiency is likely to deteriorate.

### <PARTICLES OF TITANIUM OXIDE>

In Fig. 1, the irregular surface of the tin oxide layer 5 is provided with particles of titanium oxide 6 having a specific particle size at a specific density.

The titanium oxide 6 is an oxide containing titanium as the main component, and the titanium oxide 6 is preferably composed substantially of TiO₂. The proportion of TiO₂ among components contained in the oxide is preferably at least 90 mol%, more preferably at least 95 mol%, further preferably at least 98 mol%. A material which is different from tin oxide is required for making the surface of the tin oxide layer 5 particle state. Titanium oxide is particularly preferred since titanium oxide is likely to be particle state.

Although the titanium oxide 6 is an oxide having an average size of from 1 to 100 nm, the average size is preferably from 10 to 50 nm, so that without significantly reducing contact area of the tin oxide layer and the after-mentioned photoelectric conversion layer, the coating uniformity of the after-mentioned photoelectric conversion layer can be improved.

Here, in a case where the particles of the oxide are oval shape, the average size is an average value obtained by dividing the total value of the long diameter and the short diameter by 2, and in a case where the particles of the oxide are sphere, the average size is its diameter.

The irregular surface of the tin oxide layer 5 is provided with the titanium oxide 6 at a density of from 10 to 100 particles/µm². However, the density is preferably from 20 to 70 particles/µm² so that without significantly reducing contact area of the tin oxide layer and the after-mentioned photoelectric conversion layer, the coating uniformity of the after-mentioned photoelectric conversion layer can be improved.

Here, the density is measured by taking a photograph (magnification from 50,000 to 100,000 times) of an irregular surface of the tin oxide layer by scanning electron microscope (SEM) and measuring the number of particulate oxide (titanium oxide) which is present in an optional measured area of 1 µm².

In the present invention, the titanium oxide satisfying such a size and density is formed on the irregular surface of the tin oxide layer, whereby fill factor (FF) and open circuit voltage (Voc) of a solar cell using a transparent conductive substrate for a solar cell were improved. Although the reason why the fill factor (FF) and the open circuit voltage (Voc) can be improved is not clear, the present inventors consider as follows.

That is, as shown in Fig. 2 which is a cross-sectional view schematically explaining how a photoelectric conversion layer is formed in a conventional solar cell, at a time of laminating a p layer 7a as the photoelectric conversion layer 7 on a surface of a tin oxide layer (in Fig. 2, a second tin oxide layer 5b), in a case where the surface of the tin oxide layer has irregularities, since the thickness of the p layer 7a is usually several tens nm, the p layer 7a concentrates at a top of ridge parts of the second tin oxide layer 5b, and the coating of the p layer 7a thereby will not be uniform. It is considered that at a time of film forming a p layer 7a, the film tends to attach at a top of ridge parts of the tin oxide layer 5b, and the film tends not to attach at dent parts, and accordingly the film coating will not be uniform.

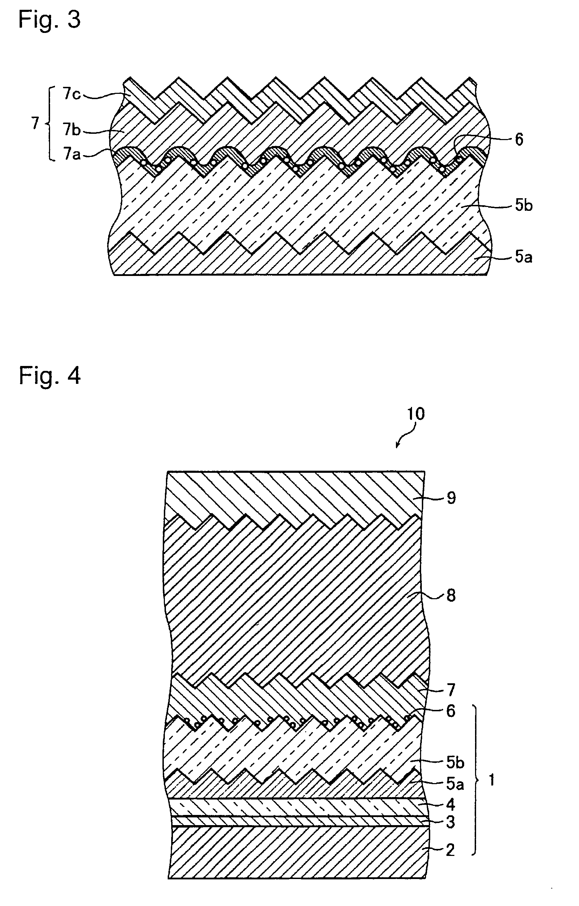

On the other hand, as shown in Fig. 3 which is a cross-sectional view schematically explaining how a photoelectric conversion layer is formed in the solar cell of the present invention, in a case where particles of the titanium oxide 6 are formed as a photoelectric conversion layer on the irregular surface of the tin oxide layer (in Fig. 3, the second tin oxide layer 5b), the diffusion of a material of the p layer 7a will be excellent, whereby a uniform coating film of the p layer 7a can be formed on the irregular surface. It is considered that since the particles of the titanium oxide 6 work similarly to the ridge parts of the tin oxide layer 5b, namely ridge parts consisting of the particles of the titanium oxide 6 are formed at the dent parts of the tin oxide layer 5b, whereby at the time of film forming a p layer 7a, not only at the ridge parts of the tin oxide layer 5b, but also at the ridge parts consisting of the particles of the titanium oxide 6, a film tends to attach. Consequently, the fill factor (FF) and the open circuit voltage (Voc) of the solar cell will be improved.

The transparent conductive substrate for a solar cell of the present invention is not particularly restricted with respect to the method for its production. For example, a method may preferably be mentioned wherein at least a silicon oxide layer, a tin oxide layer and particles of titanium oxide are formed in this order on a substrate by means of an atmospheric pressure CVD method to obtain a transparent conductive substrate for solar a cell.

Now, with respect to the method for producing the transparent conductive substrate for a solar cell will be described with reference to one example of preferred embodiment employing an atmospheric pressure CVD method.

### <FORMATION OF TITANIUM OXIDE LAYER>

A substrate 2 is heated to a high temperature (e.g. 550°C) in a heating zone, while it is transported.

Then, onto the heated substrate 2, nitrogen gas and vaporized tetraisopropoxy titanium as the raw material for the titanium oxide layer 3 which is formed as a case requires, are blown. The tetraisopropoxy titanium undergoes a thermal decomposition reaction on the substrate 2, whereupon a titanium oxide layer 3 is formed on the surface of the substrate 2 in a state of being transported.

### <FORMATION OF SILICON OXIDE LAYER>

Then, onto the substrate 2 having the titanium oxide layer 3 formed on its surface, oxygen gas and silane gas as the raw material for the silicon oxide layer 4 which is formed as a case requires, are blown. The silane gas and oxygen gas are mixed and reacted on the titanium oxide layer 3 of the substrate 2, whereupon a silicon oxide layer 4 will be formed on the surface of the titanium oxide layer 3 of the substrate 2 in a state of being transported.

### <FORMATION OF FIRST TIN OXIDE LAYER>

Then, the substrate 2 having the silicon oxide layer 4 formed on its surface, is heated again to a high temperature (e.g. 540°C), and water and tin tetrachloride as the raw material for the first tin oxide layer 5a are blown. The tin tetrachloride and water are mixed and reacted on the silicon oxide layer 4 of the substrate 2, whereupon a first tin oxide layer 5a not doped with fluorine is formed on the surface of the silicon oxide layer 4 of the substrate 2 in a state of being transported.

### <FORMATION OF SECOND TIN OXIDE LAYER>

Then, the substrate 2 having the first tin oxide layer 5a formed on its surface is heated again to a high temperature (e.g. 540°C), and tin tetrachloride, water and hydrogen fluoride as the raw material for the second tin oxide layer are blown. The tin tetrachloride, water and hydrogen fluoride are mixed and reacted on the first tin oxide layer 5a of the substrate 2, whereupon a second tin oxide layer 5b doped with fluorine is formed on the surface of the first tin oxide layer 5a of the substrate 2 in a state of being transported.

### <FORMATION OF PARTICLES OF TITANIUM OXIDE>

Then, onto the substrate 2 having the second tin oxide layer 5b formed thereon, nitrogen gas and vaporized tetraisopropoxy titanium as the raw material for particles of the titanium oxide 6 are blown. The tetraisopropoxy titanium undergoes a thermal decomposition reaction on the second tin oxide layer 5b of the substrate 2, whereupon particles of the titanium oxide 6 are formed on the surface of the second tin oxide layer 5b of the substrate 2 in a state of being transported.

Here, since in the formation of the titanium oxide, oxide particles are formed without forming a layer (titanium oxide layer), without cooling the substrate at the time of forming the tin oxide layer (in a case where plural tin oxide layers are formed, at the time of forming the outermost tin oxide layer from the substrate. Hereinafter, the same is applied in this paragraph) which is necessary to continuously form particles of the titanium oxide and the tin oxide layer, while maintaining the temperature of the substrate, it is necessary to form the particles of the titanium oxide successively after the formation of the tin oxide layer. It is considered that by maintaining the temperature of the substrate as mentioned above, the difference of activation energy results on the surface of the tin oxide layer, whereby the titanium oxide is formed on parts where the surface has a high activation energy. The temperature of the substrate is preferably from 500 to 550°C, more preferably from 520 to 550°C.

Then, while being transported, the substrate 2 having the titanium oxide 6 formed thereon, is passed through the annealing zone and cooled to the vicinity of room temperature, and discharged as a transparent conductive substrate for a solar cell.

The above-described method is an off line CVD method wherein formation of a transparent conductive substrate for a solar cell is carried out in a separate process from the production of a substrate. In the present invention, it is preferred to employ such an off line CVD method with a view to obtaining high quality transparent conductive substrate for a solar cell. However, it is also possible to employ an on line CVD method wherein formation of a transparent conductive film for a solar cell is carried out, following the production of a substrate (such as a glass substrate).

The solar cell of the present invention is a solar cell employing the transparent conductive substrate for a solar cell of the present invention.

The solar cell of the present invention may be a solar cell with either one of an amorphous silicon type photoelectric conversion layer and a fine crystal silicon type photoelectric conversion layer.

Further, it may be of either a single structure or a tandem structure. Particularly preferred is a solar cell of a tandem structure.

As one of preferred embodiments of the solar cell of the present invention, a solar cell of a tandem structure may be mentioned wherein the transparent conductive substrate for a solar cell of the present invention, a first photoelectric conversion layer, a second photoelectric conversion layer and a rear electrode layer are laminated in this order, may be mentioned.

Fig. 4 is a schematic cross-sectional view illustrating an example of the solar cell of a tandem structure employing the first embodiment of the first conductive substrate for solar cells of the present invention. In Fig. 4, the incident light side of the solar cell is located on the down side of the drawing.

The solar cell 10 shown in Fig. 4 comprises the transparent conductive substrate 1 for a solar cell of the present invention, a semiconductor layer (a photoelectric conversion layer) comprising a first photoelectric conversion layer 7 and a second photoelectric conversion layer 8, and a rear electrode layer 9. This is a common construction of a thin layer solar cell of a tandem structure.

In the solar cell 10, light enters from the side of the transparent conductive substrate 1 for the solar cell. Each of the first photoelectric conversion layer 7 and the second photoelectric conversion layer 8 has a pin structure in which a p-layer, an i-layer and an n-layer are laminated in this order from the incident light side.

Here, in the first photoelectric conversion layer 7 on the incident light side, the p-layer, the i-layer and the n-layer are made of amorphous silicon having a large band gap Eg (Fig. 3).

On the other hand, in the second photoelectric conversion layer 8 located at a further downstream side against the incident light, the p-layer, the i-layer and the n-layer are made of a crystal silicon having a small band gap Eg such as a poly-crystal silicon or a microcrystal silicon.

In Fig. 4, the second photoelectric conversion layer 8 is constructed by only one layer, but it may be constructed by laminating a plurality of photoelectric conversion layers which are different in the band gap Eg from one another. In a case where the second photoelectric conversion layer is constructed by laminating a plurality of photoelectric conversion layers, such layers are laminated so that the band gap Eg will be smaller towards the downstream from the incident light side.

Light entered into the solar cell 10 will be absorbed by either the first photoelectric conversion layer 7 or the second photoelectric conversion layer 8, whereby an electromotive force will be generated by a photoconduction effect. The electromotive force thus generated is taken out to the outside by means of the second tin oxide layer 5b being a transparent conductive film of the transparent conductive substrate 1 for a solar cell, and the rear electrode layer 9, as electrodes. The solar cell 10 has the first photoelectric conversion layer 7 and the second photoelectric conversion layer 8 which are different from each other in the band gap Eg, whereby the sunlight energy can be effectively utilized within a wide range of spectrum, and the photoelectric conversion efficiency will be excellent. Such effects will be further distinct by providing the second photoelectric conversion layer by laminating photoelectric conversion layers different in the band gap Eg from one another so that Eg will be smaller towards the downstream side from the incident light side.

The solar cell may have another layer, for example, a contact-improvement layer between the rear electrode layer 9 and the second photoelectric conversion layer 8. By providing the contact-improvement layer, the contact between the rear electrode layer 9 and the second photoelectric conversion layer 8 can be improved.

The tandem type solar cell as shown in Fig. 4 is excellent in the photoelectric conversion efficiency as compared with a conventional single type amorphous silicon solar cell. In the present invention, the absorption of near infrared light by the tin oxide layer is small, and a transparent conductive substrate for solar cells, which is excellent in the photoelectric conversion efficiency is employed, whereby the merits of the solar cell of a tandem structure will effectively be provided.

The solar cell shown in Fig. 4 can be produced by a conventional method. For example, a method may be mentioned wherein the first photoelectric conversion layer 7 and the second photoelectric conversion layer 8 are sequentially formed on the transparent conductive substrate 1 for a solar cell by means of a plasma CVD method, and further, the rear electrode layer 9 is formed by means of a sputtering method. In the case of forming a contact improvement layer, it is preferred to employ a sputtering method.

### EXAMPLES

### <PREPARATION OF TRANSPARENT CONDUCTIVE SUBSTRATE FOR SOLAR CELL>

### COMPARATIVE EXAMPLE 1

A transparent conductive substrate for a solar cell was prepared by means of an off line CVD apparatus of such a type that a plurality of gas supply devices are attached to a tunnel type heating furnace for transporting a substrate by a mesh belt. Specifically, as described below, on a glass substrate, a titanium oxide layer, a silicon oxide layer, a first tin oxide layer not doped with fluorine, a second tin oxide layer doped with fluorine and a third tin oxide layer doped with fluorine were formed in this order to obtain a transparent conductive substrate for a solar cell having such five layers laminated on the glass substrate.

Here, as the glass substrate, a soda lime silicate glass substrate having a thickness of 3.9 mm and a size of 1,400 mm × 1,100 mm was used. The gas current in the film-forming zone was uniform with a width of at least 1,400 mm of the glass width. Further, the fluctuation of the gas current would not occur toward the moving direction of the glass substrate. Accordingly, the film thickness was almost uniform over the entire region of one piece of the glass substrate.

Firstly, while the glass substrate was being transported, it was heated to 520°C in a heating zone.

Then, onto the heated substrate, vaporized tetraisopropoxy titanium as the raw material for a titanium oxide layer and nitrogen gas as a carrier gas were blown by a gas supply devices to form a titanium oxide layer on the surface of the substrate in a state of being transported. Here, tetratitanium isopropoxide was put into a bubbler tank kept at a temperature of about 100°C and vaporized by bubbling with nitrogen gas and transported to the gas supply devices by a stainless steel piping.

Then, the substrate having the titanium oxide layer formed on its surface, was heated again at 530°C and then, silane gas as the raw material for a silicon oxide layer, oxygen gas and nitrogen gas as a carrier gas were blown thereonto by the gas supply devices, to form a silicon oxide layer on the surface of the titanium oxide layer of the substrate in a state of being transported.

Further, the substrate having the silicon oxide layer formed on its surface was heated again to 540°C, and then tin tetrachloride as the raw material for a first tin oxide layer, water and nitrogen gas as a carrier gas were blown thereonto by the gas supply devices, to form a first tin oxide layer not doped with fluorine, on the surface of the silicon oxide layer of the substrate in a state of being transported. Here, tin tetrachloride was put into a bubbler tank, kept at a temperature of about 55°C, vaporized by bubbling with nitrogen gas and transported to the gas supply device by a stainless steel piping. Further, with respect to the water, steam obtained by boiling under heating was transported to the gas supply device by another stainless steel piping.

Further, the substrate having the first tin oxide layer formed on its surface was heated again to 540°C, and then, by the gas supply devices, tin tetrachloride as the raw material for a second tin oxide layer, water and nitrogen gas as a carrier gas were blown thereonto to form a second tin oxide layer doped with fluorine, on the surface of the first tin oxide layer of the substrate in a state of being transported. Here, tin tetrachloride and water were transported to the gas supply device in the same manner as in the case for the first tin oxide layer. Further, with respect to the hydrogen fluoride, vaporized hydrogen fluoride was transported to the gas supply device by a stainless steel piping and supplied in a state as mixed with tin tetrachloride onto the first tin oxide layer.

Further, the substrate having the second tin oxide layer formed on its surface was heated again to 540°C, and then, by the gas supply devices, tin tetrachloride as the raw material for a third tin oxide layer, water, hydrogen fluoride and nitrogen gas as a carrier gas were blown thereonto to form a third tin oxide layer doped with fluorine, on the second tin oxide layer of the substrate in a state of being transported. Here, tin tetrachloride, water and hydrogen fluoride were transported to the gas supply device in the same manner as the case for the second tin oxide layer.

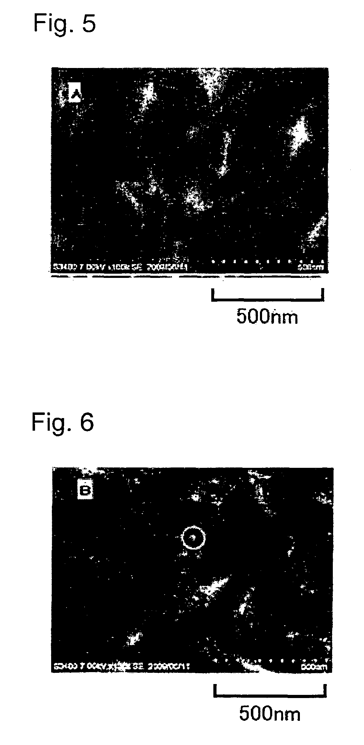

The formed third tin oxide layer had fine irregularities (texture) uniformly on the film surface as shown in a surface photograph of Fig. 5 taken by an electron microscope.

The mixing ratios of water to tin chloride in the first tin oxide layer, the second tin oxide layer and the third tin oxide layer were adjusted to H₂O/SnCl₄=30, 80 and 80 by molar ratio respectively. Further, the thicknesses of the first tin oxide layer, the second tin oxide layer and the third tin oxide layer were adjusted to be 100 nm, 270 nm and 440 nm respectively, and the total thickness was 810 nm.

Further, the amount of hydrogen fluoride added to each of the second tin oxide layer and the third tin oxide layer was HF/SnCl₄=0.4 by molar ratio.

While being transported, the substrate having the third tin oxide layer formed, was passed through an annealing zone and cooled to near room temperature, to obtain a transparent conductive substrate for a solar cell.

### EXAMPLE 1

A substrate having a titanium oxide layer, a silicon oxide layer, a first tin oxide layer not doped with fluorine, a second tin oxide layer doped with fluorine and a third tin oxide layer formed in the same manner as in Comparative Example 1 was transported to a film-forming zone for titanium oxide, while maintaining the temperature of the substrate after the formation of the third tin oxide layer at the vicinity of 500°C. The substrate was heated by a heater during the transportation for maintaining the temperature of the substrate.

After the substrate was transported to the film-forming zone for titanium oxide, vaporized tetraisopropoxy titanium (TIPT) as the raw material for particles of titanium oxide and nitrogen gas as a carrier gas were blown by the gas supply devices to form particles of titanium oxide on the surface of the substrate in a state of being transported. Here, tetratitanium isopropoxide was put into a bubbler tank kept at a temperature of about 115°C and vaporized by bubbling with nitrogen gas and transported to the gas supply device by a stainless steel piping.

The formed third tin oxide layer had fine irregularities (texture) on the film surface as shown in a surface photograph of Fig. 6 taken by an electron microscope, and particles of the titanium oxide having the average size and density shown in Table 1 were formed on the surface. Further, in Fig. 6, one of the titanium oxide is circled by a white circle.

Then, while being transported, the substrate having the titanium oxide formed, was passed through an annealing zone and cooled to near room temperature, to obtain a transparent conductive substrate for a solar cell.

### EXAMPLES 2 AND 3

Transparent conductive substrates for a solar cell were obtained in the same manner as in Example 1 except that in the first tin oxide layer, the second tin oxide layer and the third tin oxide layer, the thickness, the HF/SnCl₄ molar ratio and the H₂O/SnCl₄ molar ratio were changed as shown in Table 1.

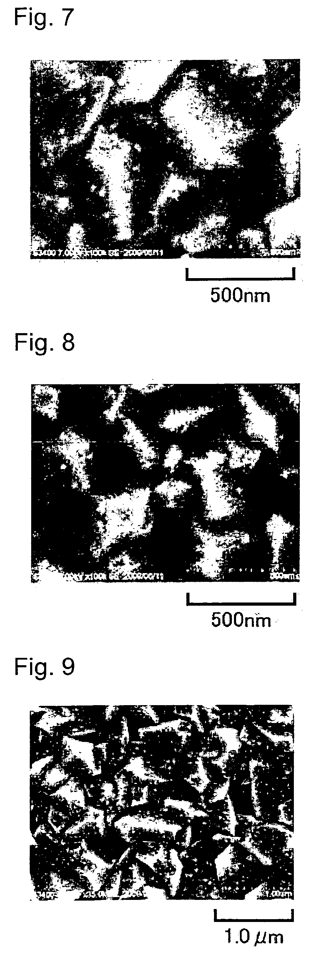

Further, also in Examples 2 and 3, the third tin oxide layers had fine irregularities (texture) on the film surface as shown in surface photographs of Figs. 7 and 8 taken by an electron microscope, and particles of the titanium oxide having the average size and density shown in Table 1 were formed on the surface.

### EXAMPLE 4

A transparent conductive substrate for a solar cell was obtained in the same manner as in Example 1 except that in the first tin oxide layer, the second tin oxide layer and the third tin oxide layer, the thickness, the HF/SnCl₄ molar ratio and the H₂O/SnCl₄ molar ratio were changed as shown in Table 1, and the amount of TIPT to be supplied (bubbling N₂ flow rate (L/min)) as the raw material for titanium oxide to be formed on the third tin oxide layer was changed as shown in Table 1.

Further, also in Example 4, the third tin oxide layers had fine irregularities (texture) on the film surface as shown in surface photographs of Fig. 9 taken by an electron microscope, and particles of the titanium oxide having the average size and density shown in Table 1 were formed on the surface, like Example 1.

With respect to the thus obtained transparent conductive substrates for a solar cell, the haze factor for illuminant C was measured by the following manner. The results are shown in Table 1.

Specifically, with respect to a sample for measurement cut out from a transparent conductive substrate for solar cells, the haze factor for illuminant C was measured by means of a haze meter (HZ-1 model, manufactured by SUGA TEST INSTRUMENTS Co., Ltd.).

Here, the haze factor of the entire surface of the substrate is visually substantially uniform. Therefore, a typical portion of the substrate was selected and cut out to obtain a sample for measurement.

**TABLE 1**

| | First tin oxide layer | | | Second tin oxide layer | | | Third tin oxide layer | | | Titanium oxide (particles) | | | Haze factor for illuminant C(%) |
|---|---|---|---|---|---|---|---|---|---|---|---|---|---|
| | Thickness (nm) | HF/ SnCl₄ molar ratio | H₂O/ SnCl₄ molar ratio | Thickness (nm) | HF/ SnCl₄ molar ratio | H₂O/ SnCl₄ molar ratio | Thickness (nm) | HF/ SnCl₄ molar ratio | H₂O/ SnCl₄ molar ratio | Amount of supplied TIPT (bubbling N₂ flow amount) | Average size (nm) | Density (particles/µm²) | |
| Comp. Ex.1 | 100 | 0.0 | 30 | 270 | 0.4 | 80 | 440 | 0.4 | 80 | - | - | - | 10% |
| Ex.1 | 100 | 0.0 | 30 | 270 | 0.4 | 80 | 440 | 0.4 | 80 | 4.5 | 25 | 20 | 10% |
| Ex.2 | 270 | 0.0 | 80 | 270 | 0.4 | 80 | 270 | 0.4 | 80 | 4.5 | 27 | 57 | 27% |
| Ex.3 | 100 | 0.0 | 10 | 270 | 0.4 | 80 | 440 | 0.4 | 80 | 4.5 | 27 | 22 | 19% |
| Ex.4 | 270 | 0.0 | 80 | 270 | 0.4 | 80 | 270 | 0.4 | 80 | 9.0 | 30 | 38 | 30% |

### <PREPARATION OF A SOLAR CELL>

Solar cells were produced by forming photoelectric conversion elements by using the transparent conductive substrate for a solar cell prepared in Comparative Example 1 and Example 1 by the following procedure.

### (a) FORMATION OF PHOTOELECTRIC CONVERSION LAYER

The transparent conductive substrate for a solar cell was cut into a size of 40 mm × 40 mm and washed. Then, a photoelectric conversion layer having a p-i-n junction (positive semiconductor layer, p/i buffer layer, intrinsic semiconductor layer, negative semiconductor layer) was formed on the substrate by a plasma CVD device (SLCM-14, manufactured by Shimadzu Corporation).

Each layer of the p-i-n junction was formed by the following condition. The thickness of the positive semiconductor layer was 11 nm, the thickness of the p/i buffer layer was 6 nm, the thickness of the intrinsic semiconductor layer was 350 nm, and the thickness of the negative semiconductor layer was 40 nm. Further, as the intrinsic semiconductor layer, an amorphous silicon layer was used.

### (FORMATION OF THE POSITIVE SEMICONDUCTOR LAYER)

Substrate surface temperature: 180°C
Fill formation pressure: 40 Pa
RF making electrical power: 30 mW/cm²
Gas flow amount SiH₄: 10 sccm
Gas flow amount CH₄: 20 sccm
Gas flow amount H₂: 20 to 120 sccm
Gas flow amount B₂H₆/H₂: 100 to 0 sccm (1,000 ppm of B₂H₆ in H₂)

The gas flow amount of H₂ and B₂H₆/H₂ were gradually changed during the film formation.

### (FORMATION OF p/i BUFFER LAYER)

Substrate surface temperature: 180°C
Fill formation pressure: 40 Pa
RF making electrical power: 30 mW/cm²
Gas flow amount SiH₄: 10 sccm
Gas flow amount CH₄: 20 to 0 sccm
Gas flow amount H₂: 100 sccm

The gas flow amount of CH₄ were gradually changed during the film formation.

### (FORMATION OF INTRINSIC SEMICONDUCTOR LAYER)

Substrate surface temperature: 180°C
Fill formation pressure: 27 Pa
RF making electrical power: 30 mW/cm²
Gas flow amount SiH₄: 10 sccm

### (FORMATION OF NEGATIVE SEMICONDUCTOR LAYER)

Substrate surface temperature: 180°C
Fill formation pressure: 27 Pa
RF making electrical power: 30 mW/cm²
Gas flow amount SiH₄: 10 sccm
Gas flow amount H₂: 100 sccm
Gas flow amount PH₃/H₂: 100 sccm (1,000 ppm of PH₃ is contained in H₂)

### (b) FORMATION OF REAR ELECTRODE

A rear electrode consisting of a gallium-doped zinc oxide layer (GZO layer) and an Ag layer with an area of 5 mm × 5 mm was formed on the formed photoelectric conversion layer by the following method.

40 nm of a GZO film was formed by using a GZO target having 5.7 mass% of gallium oxide based on the total amount of gallium oxide and zinc oxide by the DC sputtering method. Here, the composition of the GZO layer is the same as the target. The pressure of a sputtering device was preliminarily reduced to 10⁻⁴ Pa, and then 75 sccm of Ar gas and 1 sccm of CO₂ gas were introduced, the pressure of the sputtering device was adjusted to 4×10⁻¹ Pa, and a film was formed at a sputtering powder of 2.4 W/cm²_{.}

Then, 200 nm of an Ag layer was formed with a silver target. Here, the composition of the Ag layer is the same as the target. Here, Ar gas was introduced into a sputtering device, the pressure of the sputtering device was adjusted to 4×10¹ Pa, and a film was formed at a sputtering power of 1.4 W/cm².

The solar cell thus obtained was irradiated with light (light intensity: 100 mW/cm²) having AM (air mass) of 1.5 by a solar simulator (CE-24 model solar simulator manufactured by Opto Research Corporation) to measure electric current-voltage characteristics, whereby a fill factor (ff) and open circuit voltage (Voc) were obtained. Results are shown in Table 2.

**TABLE 2**

| | Open circuit voltage | Fill factor |
|---|---|---|
| Comp. Ex. 1 | 1.000 | 1.000 |
| Ex. 1 | 1.009 | 1.014 |

It is evident from Table 2 that as compared with the solar cell prepared in Comparative Example 1 without forming anything between the tin oxide layer (the third tin oxide layer) and the photoconversion layer, in the case of the solar cell prepared in Example 1 by forming particles of titanium oxide on a surface of the tin oxide layer (the third tin oxide layer), the open circuit voltage (Voc) was improved by 0.9%, and the fill factor (FF) was improved by 1.4%.

### INDUSTRIAL APPLICABILITY

If the transparent conductive substrate for a solar cell of the present invention is used, the fill factor (FF) and the open circuit voltage (Voc) of a solar cell using such a substrate are improved. Thus, the transparent conductive substrate for a solar cell of the present invention is industrially useful.

The entire disclosure of Japanese Patent Application No. 2009-176401 filed on July 29, 2009 including specification, claims, drawings and summary is incorporated herein by reference in its entirety.

### REFERENCE SYMBOLS

1: Transparent conductive substrate for a solar cell
2: Substrate
3: Titanium oxide layer
4: Silicon oxide layer
5: Tin oxide layer
5a: First tin oxide layer
5b: Second tin oxide layer
6: Titanium oxide layer
7: First photoconversion layer
7a: p layer
7b: i layer
7c: n layer
8: Second photoelectric conversion layer
9: Rear electrode layer
10: Solar cell

## Claims

1. A transparent conductive substrate for a solar cell, comprising a substrate and at least a tin oxide layer formed thereon, wherein the tin oxide layer has ridges and dents on a surface which is not on the substrate side, an oxide having titanium as the main component is formed on the surface having the ridges and dents, the oxide is particles having an average size of from 1 to 100 nm, and the oxide is contained at a density of from 10 to 100 particles/µm².

2. The transparent conductive substrate according to Claim 1, wherein the average size of the oxide is from 10 to 50 nm.

3. The transparent conductive substrate according to Claim 1 or 2, wherein the density of the oxide is from 20 to 70 particles/µm².

4. The transparent conductive substrate according to any one of Claims 1 to 3, wherein the tin oxide layer is formed at a temperature of the substrate of from 500 to 550°C, and the oxide is formed on the tin oxide layer while maintaining the temperature of the substrate at the time of forming the tin oxide layer.

5. The transparent conductive substrate according to Claim 1, wherein on a surface of the tin oxide layer having ridges and dents wherein the height difference between ridge parts and dent parts of the ridges and dents on the tin oxide layer is from 0.1 to 0.5 µm, and pitches between the ridge parts of the ridges and dents is from 0.1 to 0.75 µm, particles of the oxide having titanium as the main component and having an average size of from 1 to 100 nm are formed at a density of from 10 to 100 particles/µm².

6. A solar cell, which has the transparent conductive substrate for a solar cell as defined in any one of Claims 1 to 5.

7. A process for producing the transparent conductive substrate for a solar cell as defined in any one of Claims 1 to 5, which comprises at least a tin oxide layer forming step of forming the tin oxide layer on the substrate and an oxide forming step of forming the oxide on the surface of the tin oxide layer for obtaining a transparent conductive substrate for a solar cell, wherein the temperature of the substrate at the tin oxide layer forming step and the oxide forming step is from 500 to 550°C, and the temperature of the substrate is maintained at from 500 to 550°C between these steps.

8. The process for producing the transparent conductive substrate for a solar cell according to Claim 7, wherein the tin oxide layer forming step of forming the tin oxide layer having ridges and dents on a surface is carried out by an atmospheric pressure CVD method, the oxide forming step of forming oxide particles having titanium as the main component on the surface of the tin oxide layer having ridges and dents on a surface formed by the atmospheric pressure CVD method is carried out by an atmospheric pressure CVD method, and the oxide at the oxide forming step is formed on the tin oxide layer, while maintaining the temperature of the substrate at the time of forming the tin oxide layer in the tin oxide layer forming step.
